Europäisches Patentamt

European Patent Office

Office européen des brevets

(19)

(11) Publication number: **0 248 953**
**A1**

# (12) EUROPEAN PATENT APPLICATION

(21) Application number: 86304432.7

(22) Date of filing: 10.06.86

(51) Int. Cl.4: **H01L 31/06** , **H01L 25/08**

(43) Date of publication of application:
**16.12.87 Bulletin 87/51**

(84) Designated Contracting States:
**CH DE FR GB IT LI NL**

(71) Applicant: **THE STANDARD OIL COMPANY**
**200 Public Square, 36-F-3454**
**Cleveland Ohio 44114-2375(US)**

(72) Inventor: **Biter, William J.**
**124 Shussex Road**
**Hudson Ohio 44236(US)**
Inventor: **Schwabe, James E.**
**3050 Farnham Road**
**Richfield Ohio 44286(US)**

(74) Representative: **Jackson, Peter Arthur et al**
**GILL JENNINGS & EVERY 53-64 Chancery**
**Lane**
**London WC2A 1HN(GB)**

(54) **Tandem photovoltaic devices.**

(57) A photovoltaic device (10) includes an optically transparent, electrically conductive layer (22) and a second electrically conductive layer (13) both of which provide contact areas for electrodes. The photovoltaic device (10) consists of a plurality of at least two cells (11/12) in a tandem configuration. A first cell (11) may be made of an amorphous semiconductor and a second cell (12) may be made of two semiconductor layers (15/14) of different compounds having a heterojunction (16) therebetween. The amorphous semiconductor layer (21) of the one cell (11) has a surface which contacts the optically transparent, electrically conductive layer (22). One of the two semiconductor layers (14) of the second cell (12) has a surface which electrically contacts the second conductive layer (13). Means (18) for example a transparent, conductive layer, such as indium tin oxide, or a tunnel diode structure are provided to connect another surface of the first cell (11) and another surface to the second cell (12) so that the cells (11/12) are optically and electrically in series.

FIG.1

# TANDEM PHOTOVOLTAIC DEVICES

## TECHNICAL FIELD

The present invention generally relates to photovoltaic devices used to convert solar energy to electrical energy. More specifically the present invention relates to photovoltaic devices having a plurality of cells arranged in a tandem configuration.

## BACKGROUND ART

Photovoltaic devices utilize specific conductivity characteristics of materials generally referred to as semiconductors, whereby solar energy or radiation is converted to useful electrical energy. This conversion results from the absorption of photon energy in the active region of the cell, whereby some of the absorbed energy causes the generation of electron-hole pairs. The energy required for the generation of electron-hole pairs in a semiconductor material is referred to as the bandgap energy and generally is the minimum energy required to excite an electron from the valence band to the conduction band.

Solar radiation comprises photons having different energy levels, in part characterized by the different wavelengths of the light. Since any given cell has a fixed energy bandgap, each cell will only respond to certain wavelengths of light impinging thereon. Thus, not all of the photon energy impinging on a cell will be absorbed so as to free electrons. The remaining energy is either passed through and lost or dissipated as heat.

There are two principal measures of the utility of photovoltaic devices. First is the efficiency of the device, which is an ascertainable percentage of the total photon energy converted to useful electrical energy. High efficiency solar cells made of crystalline silicon, for example, can attain efficiencies of about 18 percent. The use of single crystal cells maximizes efficiency by minimizing internal lattice defects which can cause internal shorts and boundary defects thereby reducing the conductivity and recombination characteristics of the cells.

The second measure of the utility of a photovoltaic device is its cost. Single crystal cells are complex and costly to produce, and do not readily lend themselves to high volume production. One approach to reducing the cost of photovoltaic devices is to utilize polycrystalline materials generally incorporating a heterojunction therein. A heterojunction refers to the active junction formed at the interface between two or more dissimilar materials such as CdS and CdTe as taught by Basol et al. in United States patent 4,388,483. A disadvantage of such polycrystalline heterojunction devices is their lower efficiency, generally ten percent or less.

Another approach to reducing the cost of photovoltaic devices occurred with the introduction of thin amorphous semiconductor materials. An amorphous photovoltaic device generally utilizes a homojunction, that is, an active junction formed at the interface of two similar materials such as p-type silicon and n-type silicon. A basic example of such a homojunction is an n-type silicon layer with a p-type impurity diffused therein. Such amorphous homojunction cells are disclosed by Ovshinsky et al. in United States patent 4,409,605. However, amorphous semiconductor materials are generally not as efficient as crystalline materials, having efficiencies of about ten percent or less.

Recently, high efficiency photovoltaic devices have been sought by the use of a tandem configuration wherein a plurality of cells having variant bandgaps may be optically and electrically arranged in series. A typical example of such a device is shown in United States patent no. 4,253,882, wherein an amorphous silicon cell is formed on a crystalline silicon cell, both cells utilizing homojunction active areas. The amorphous cell has a higher bandgap than the crystalline cell and consequently absorbs the photons having higher energy. An optically transparent tunnel diode electrically connects the cells in series. The crystalline cell absorbs the lower energy photons so that the overall spectral response of the tandem device is greater than either of the individual cells alone. Efficiencies exceeding 10 percent, therefore, are obtainable.

Another example of a tandem solar cell is shown in United States patent no. 4,292,461 and comprises an amorphous cell disposed over a crystalline cell, electrically joined in series by an ohmic contact. This patent shows a multiple bandgap cell wherein the two cells (crystalline or polycrystalline) are separated by an insulator and optionally connectable in series by a wraparound conductor. United States patent no. 4,332,974 shows a plurality of stacked homojunction devices serially connected by tunnel diodes.

While the tandem solar cells revealed in the prior art show an improvement in overall efficiency, the continued reliance on crystalline and polycrystalline cells and complex interconnection methods has maintained costs beyond the realm of practical and widespread usage. It is clear, therefore, that the need exists for a tandem solar cell configuration which achieves high efficiency at a substantially reduced cost, preferably utilizing production processes currently available.

It is, therefore, a primary object of the present invention to provide an improved photovoltaic device having a tandem configuration.

It is another object of the present invention to provide a photovoltaic device which has at least two cells electrically and optically in series such that the overall efficiency of the device is greater than the singular efficiency of one cell.

It is yet another object of the present invention to provide a photovoltaic device having substantially improved efficiency at a minimal cost of production.

It is still another object of the present invention to utilize available fabrication processes in a novel and improved way to make an improved photovoltaic device.

These and other objects of the present invention will become apparent in the description of the invention and drawings that follow.


SUMMARY OF THE INVENTION

The invention generally relates to a photovoltaic device having an optically transparent, electrically conductive layer and a second electrically conductive layer comprising: a plurality of cells including a first cell of one amorphous semiconductor material, the amorphous semiconductor material disposed as an active layer having a surface contacting the optically transparent, electrically conductive layer; and at least a second cell, which second cell has first and second semiconductor layers having different conductivity types, the first semiconductor layer having a surface electrically contacting the second electrically conductive layer, and means to connect the cells so that the same are optically and electrically in series in a tandem configuration.

The invention also relates to a photovoltaic device having an optically transparent, electrically conductive layer and a second electrically conductive layer, the photovoltaic device comprising at least one amorphous silicon cell disposed as an active layer having one surface in contact with the optically transparent, electrically conductive layer; and a cell comprising a layer of cadmium sulfide (CdS) and a layer of cadmium telluride (CdTe) in tandem configuration with the at least one amorphous silicon cell, the cadmium telluride layer in contact with the second electrically conductive layer, the device further having means to optically and electrically connect the cells in series.

This invention further relates to a process for the production of a multiple cell photovoltaic device having at least one cell comprising an amorphous semiconductor material and at least one cell comprising first and second semiconductor layer composed of materials having different conductivity types, the process resulting in cells that are optically and electrically in series and comprising the steps of:

a) depositing a first semiconductor layer having a first conductivity type onto an electrically conductive substrate;

b) depositing a second semiconductor layer having a conductivity type different than the conductivity type of the first semiconductor layer onto the first semiconductor layer;

c) depositing onto the second semiconductor layer a layer of an optically transparent, electrically conductive material; and

d) depositing onto the optically transparent, electrically conductive material layers of an amorphous semiconductor material and layers of a transparent, electrically conductive material so as to form at least one amorphous cell thereon with a transparent, electrically conductive layer disposed on each amorphous cell.

Additionally, the invention relates to a process for the production of a multiple cell photovoltaic device having at least one cell comprising an amorphous semiconductor material and at least one cell comprising first and second semiconductor layer composed of materials having different conductivity types, which process results in cells that are optically and electrically in series and comprises the steps of:

a) depositing onto an optically transparent, electrically conductive substrate layer of an amorphous material and layers of a transparent, electrically conductive material so as to form at least one amorphous cell thereon with a layer of a transparent, electrically conductive material disposed on each such amorphous cell;

b) depositing a first semiconductor layer having a first conductivity type onto the exposed transparent, electrically conductive layer;

c) depositing a second semiconductor layer of a conductivity type different than the conductivity type of the first semiconductor layer onto the first semiconductor layer; and

d) depositing onto the second semiconductor layer a layer of an electrically conductive material.

## DETAILED DESCRIPTION OF THE INVENTION

In general, an improved and novel photovoltaic device according to the concepts of the present invention includes an optically transparent, electrically conductive layer and a second electrically conductive layer, both of which provide contact areas for electrodes. The photovoltaic device consists of at least two cells in a tandem configuration. One of the cells is made of an amorphous semiconductor, generally having a homojunction associated therewith, and another cell is made of two semiconductor layers of different compounds, usually typified in that a heterojunction is formed therebetween. One layer of the amorphous semiconductor cell has a surface which contacts the optically transparent, electrically conductive layer through which layer radiated energy enters the photovoltaic device. One of the layers of the cell comprising two different semiconductor layers has a surface which contacts the second electrically conductive layer. Means are provided to connect the cells so that the cells are optically and electrically in series in the tandem configuration.

The amorphous semiconductor cell may comprise amorphous silicon. The cell comprising two different semiconductor layers may include semiconductor layers such as Class IIB-VIA semiconductor compounds like CdTe/CdS and HgCdTe/CdS, $Cu_2S$/CdS, $CuInDe_2$/CdS and GaAs/GaAlAs.

Preferably, the photovoltaic devices in accordance with this invention include a CdTe/CdS cell and an amorphous silicon cell and a HgCdTe/CdS cell and an amorphous silicon cell. A cell comprising cadmium telluride and cadmium sulfide has a bandgap energy of about 1.5 eV. A cell comprising mercury cadmium telluride and cadmium sulfide may have a bandgap energy of from about 1.2 eV to about 1.5 eV. Amorphous silicon provides a cell having a bandgap energy of from about 1.5 eV to about 1.8 eV. Thus a tandem configuration of these cells, although not ideally optimized, will be highly efficient.

The cadmium telluride-cadmium sulfide and mercury cadmium telluride-cadmium sulfide cells may be produced by deposition techniques known to those skilled in the art, such as vacuum deposition, spray deposition and electrodeposition. Of special applicability are the electrolytic deposition processes taught in United States patent 4,388,483 to Basol et al. and United States patent 4,400,244 to Kroger et al., which teachings are incorporated herein by reference. By the above practices, an n-type conductivity layer of a Class IIB-VIA compound, such as cadmium sulfide, cadmium selenide, zinc oxide, zinc selenide or cadmium zinc selenide may be deposited on an electrically conductive substrate material, after which a layer of a semiconductor compound is deposited in touching contact with the n-type conductivity layer. With respect to the semiconductor compound, the compounds that are preferred are cadmium telluride and mercury cadmium telluride. However, other compounds formed of at least one of the metal elements of Class IIB of the Periodic Table of Elements and at least one non-metal of Class VIA of the Periodic Table of Elements may be used. Specific examples of such compounds are cadmium tellurium selenide, cadmium telluride sulfide and zinc telluride. Such a semiconductor compound may be initially an n-type semiconductor compound or a near intrinsic semiconductor compound such as high resistivity p-type semiconductor compounds or an intrinsic semiconductor compound. In any event, after heat treatment such semiconductor compound becomes a suitable low resistivity p-type semiconductor compound.

The amorphous silicon cell may comprise a p-n junction or p-i-n junction cell such as that described in United States patent 4,409,605 to Ovshinsky et al. Amorphous silicon alloys can be deposited in multiple layers over large area substrates to form photovoltaic devices in a high volume, continuous processing system. Such continuous processing systems are disclosed in United States patents 4,400,409 entitled "A Method of Making P-Doped Silicon Films and Devices Made Therefrom"; 4,410,588, entitled "Continuous Amorphous Solar Cell Production System"; and 4,438,723, entitled "Multiple Chamber Deposition and Isolation System and Method". As disclosed in these patents, a substrate may be continuously advanced through a succession of interconnected, environmentally protected deposition chambers, wherein each chamber is dedicated to the deposition of a specific semiconductor material. In making a photovoltaic device, for instance, of p-i-n type configurations, the first chamber is dedicated for depositing a p-type semiconductor alloy. The second chamber is dedicated for depositing an intrinsic amorphous semiconductor alloy, and the third chamber is dedicated for depositing an n-type semiconductor alloy. Such amorphous semiconductor materials may be formed by doping the various p, i and n layers with dopants such as phosphorus and arsenic to produce an n-type conductivity layer, and boron, aluminum, gallium, and indium to produce a p-type conductivity layer. As an example, United States Patent 4,400,409 to Izu et al. teaches a method of making p-doped silicon films by utilizing previously known p-dopant metal or boron gaseous materials in unique forms and conditions in a glow discharge silicon, preferably hydrogen and fluorine compensated, deposition process. It is noted that as used herein the term "p-i-n type" refers to any sequence of p and n or p, i and n semiconductor alloy layers.

The combinations of at least one CdTe/CdS or one HgCdTe/CdS cell and at least one amorphous silicon cell are well-suited for incorporation in a tandem configuration since a substrate having at least one CdTe/CdS or one HgCdTe/CdS cell disposed thereon using techniques developed for such cells may then be subject to deposition processes for the formation of at least one amorphous silicon cell thereon without adversely affecting the properties of the CdTe/CdS or HgCdTe/CdS cell.

The tandem configuration of the present invention is not limited to a two-cell tandem configuration. Additional cells may be utilized to further increase the efficiency of the tandem configuration. Thus, a tandem configuration in accordance with this invention may comprise two or more amorphous cells disposed in a tandem configuration with at least one cell comprising two semiconductor layers of different conductivity type materials.

It is preferred that each cell of the tandem possess a bandgap energy range that is not identical to the bandgap energy range of the other cells of the tandem so that as light energy is transmitted through the tandem configuration, it is absorbed by cells having decreasing bandgap energies. Cells of varying bandgaps occur when different semiconductor materials are used and when the same semiconductor material is alloyed with another material. Thus, a preferred tandem configuration in accordance with this invention may comprise two or more amorphous cells disposed in a tandem configuration, each cell having a different bandgap energy range such that each cell through which light penetrates has a lower bandgap energy range than the previous cell, and at least one cell disposed therebelow comprising two semiconductor layers of different conductivity type materials having a bandgap energy range that extends lower than the amorphous cells.

## BRIEF DESCRIPTION OF THE DRAWINGS

The invention is more fully described herein below and with reference to the accompanying figures wherein:

Figure 1 is a schematic cross sectional representation of a photovoltaic device in accordance with the present invention; and

Figure 2 is a schematic cross sectional representation of an alternative embodiment of a photovoltaic device in accordance with the present invention.

## DETAILED DESCRIPTION OF THE DRAWINGS

In the description of the drawings which follows, it is to be noted that various cell layers have been intentionally drawn disproportionate and not to scale so as to provide clarity for the details of the present invention. It will also be appreciated by those skilled in the art that the various designations herein of p-type and n-type materials are for exemplary purposes only and are not to be construed as limiting the scope of the present invention.

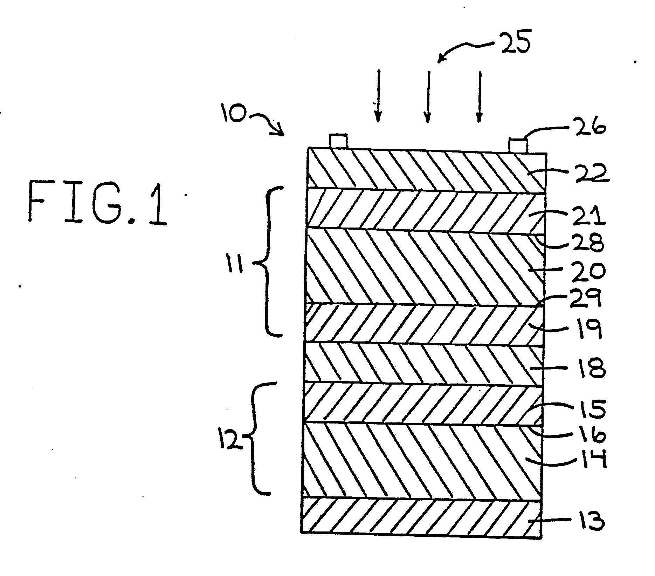

Referring to Figure 1, there is depicted therein a photovoltaic device, generally indicated by the number 10, having a tandem configuration in accordance with the present invention. Device 10 includes a plurality of cells, generally indicated by the numerals 11 and 12, in a tandem configuration. While the preferred embodiment shown and described herein depicts two cells in tandem, such description is for exemplary purposes only and is not to be construed as limiting in any sense. Device 10 includes a substrate 13 which may be selected so as to provide both a structural foundation for device 10 as well as an electrical contact for one of the electrodes (not shown) used to connect device 10 electrically to either another photovoltaic device or an electrical load. Substrate 13 may be a conductive layer of stainless steel, although other substrates may be equally suitable. When the cell 12 is a CdTe/CdS or a HgCdTe/CdS cell, substrate 13 may include a chromium coating with a gold layer thereon (not shown). The chromium layer acts as a diffusion barrier and the gold provides an ohmic contact surface for device 10. Because substrate 13 may be made of non-transparent material it may also provide a reflective surface to light which may penetrate through device 10 without initially being absorbed by the plurality of cells.

Cell 12 may next be formed on layer 13. Cell 12 includes a first semiconductor layer 14 and a second semiconductor layer 15 formed on layer 14, layer 15 being made of a different compound than that used for layer 14. A heterojunction 16 is generally formed between contiguous layers 14 and 15. A heterojunction device is desirable for cell 12 because of its very low production cost. Cell 12 is characterized by thin semiconductor layers, of from about 0.1 micrometer to about 1.0 micrometer, and ease of deposition. Cell 12 may be formed on layer 13 by techniques known to one skilled in the art. In the preferred embodiments, a p-type CdTe or HgCdTe layer may be used. A surface of layer 14 is disposed in touching contact with a surface of layer 13. The p-type characteristic can be achieved by either depositing a CdTe or HgCdTe layer and then heat treating in air or by ion implantation or doping of the CdTe or HgCdTe with an appropriate impurity. Such methods are known to one skilled in the art. Layer 15 of CdS may then be deposited on layer 14 using similar techniques.

After cell 12 has been formed on conductive layer 13, an optically transparent, electrically conductive layer 18 may be formed on the exposed surface of layer 15. Layer 18 forms an ohmic connection between cells 11 and 12. To maximize the efficiency of device 10, indium-tin-oxide (ITO) has been found to be most suitable as layer 18 due to its optical transparency. Another advantage of the ITO layer is that the deposition can be done with conventional techniques known to one skilled in the art at temperatures compatible with the cell 12. It will thus be appreciated that according to the concepts of the present invention, cells 11 and 12 are optically and electrically in series. Other connection means could be used in place of the ITO layer such as a tunnel diode or metallic strips or islands, however, the ITO layer provides a maximum transmission of light from cell 11 to cell 12 with minimal current and energy losses due to recombination or resistance. It will be appreciated by one skilled in the art that if more than two cells will be used there will preferably be a corresponding connecting layer between each pair of cells so that all the cells are optically and electrically in series.

After layer 18 has been formed on cell 12, cell 11 may next be disposed onto layer 18. Cell 11 comprises an amorphous semiconductor cell. The amorphous cell has a moderately high efficiency while at the same time a lower production cost over its crystalline and polycrystalline counterparts. Though a conventional N-I-P amorphous cell structure is shown in Figure 1, it will be appreciated that other cell structures could be used such as Schottky of MIS, or amorphous with microcrystalline p-type and n-type layers. The amorphous cell 11 shown herein was selected to provide high efficiency at minimal cost.

Cell 11 preferably comprises amorphous silicon and may be formed on layer 18 using well-known fabrication techniques. This may be done in a vacuum chamber wherein silicon containing compounds such as silane $(SiH_4)$ are deposited on layer 18 at about 250°C. One preferred fabrication technique is taught by Ovshinsky et al in United States patent 4,226,989 wherein an amorphous silicon-fluorine-hydrogen alloy is deposited from precursor materials such as silane, silicon tetrafluoride and hydrogen. As noted herein above, deposition temperatures of about 250°C are completely compatible with heterojunction cell 12 already formed when cell 12 is CdTe/CdS or HgCdTe/CdS. The silicon-hydrogen alloy or silicon-fluorine-hydrogen alloy is useful to compensate for the lattice deficiencies otherwise present in the amorphous silicon semiconductor layer. Of course, amorphous semiconductor materials other than silicon could be used.

Cell 11 may include three distinct and contiguous layers; a p-type layer 19, an intrinsic layer 20 and an n-type layer 21. P-type layer 19 may be made by doping the silane compound, as by adding diborane to the silane gas during the vacuum deposition process. Intrinsic layer 20 may be formed by depositing silane directly, possibly mixed with hydrogen to control its properties. N-type layer 21 may be made by then adding phosphine to the silane gas during the deposition after layer 20 has been formed. Thus, a complete N-I-P solar cell has been formed on conductive layer 18 and optically in series with cell 12. Layers 21 and 19 are made very thin to minimize light absorption. Light absorption in cell 11 occurs almost exclusively in intrinsic layer 20. Alternatively a single junction amorphous semiconductor cell could be made of two layers appropriately doped p-type and n-type and not using a third intrinsic layer.

After cell 11 has been formed, another layer of optically transparent, electrically conductive material 22 may be formed on the exposed surface of layer 21. Layer 22 provides an electrical contact area to cell 11 but must be optically transparent because light energy, generally indicated in Figure 1 by the numeral 25, will enter device 10 through the exposed surface of layer 22. An electrode grid 16 may be formed on layer 22 to efficiently collect electric current and to provide an electrode current (not shown) such that the device 10 may be electrically coupled to other devices or an electrical load.

The advantages of device 10 herein disclosed are readily apparent to one skilled in the art. In operation, light energy enters device 10 through optically transparent, electrically conductive layer 22 and thereafter into layer 20 of cell 11. Because cell 11 is an amorphous semiconductor structure it may have a moderately high bandgap of about 1.8 eV. Thus, layer 20 only absorbs higher energy photons. That portion of the spectrum having photons of energy less than the bandgap of cell 11 penetrate through cell 11, through the optically transparent connecting layer 18 and thereafter into cell 12. Cell 12 absorbs the lower light energy transmitted through cell 11. The absorption principally occurs in layer 14 when the cell 12 is a CdTe/CdS or HgCdTe/CdS cell.

The absorption of light energy in layers 20 and 14 causes electron-hole pairs to be formed. Cell 12 is shown having an active heterojunction 16, described hereinabove, and cell 11 is shown having two active homojunctions 28 and 29, formed between layers 21 and 20, and 20 and 19, respectively. According to the basic principals of photovoltaic devices, the active junctions permit the separation of the photovoltaically created hole-electron pairs thus creating a voltage potential and associated current. The currents and voltages thus created in cells 11 and 12 are electrically connected in series by layer 18 and device 10 acts as a converter of solar or light energy to electrical energy. As stated hereinabove, conductive layers 22 and 13 provide contact areas to allow device 10 to be coupled to other devices or an electrical load.

The tandem configuration of device 10 results in a device having a greater efficiency than any one of its constituent cells. This is because of greater percentage of total incident light energy is converted per device. The novel combination of an amorphous cell and a cell having two semiconductor layers of different conductivity types, separately made using different but compatible processing techniques provides high efficiency (greater than 12-14 percent) at a substantially reduced production price because of the high volume processing techniques and the lower cost of materials, as well as the compatibility of the processes for making these two types of cells which come from separate technical origins. Again, more than two cells may be used and may provide greater efficiency. The cells would be stacked in order of decreasing bandgap energy referenced to the path of the light energy.

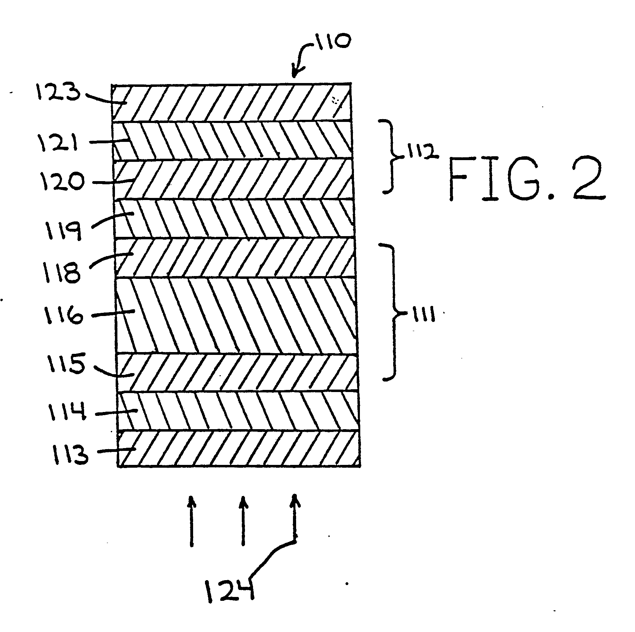

Figure 2 demonstrates an alternative embodiment according to the concepts of the present invention. A photovoltaic device is generally indicated by the numeral 110 and includes a plurality of light sensitive cells, generally indicated by the numerals 111 and 112, in a tandem configuration. Again, though the use of only two cells in tandem is described herein, such is for exemplary purposes only and is not to be construed as limiting in any sense. More cells may be used according to the present invention as is clear from the disclosure herein.

Device 110 includes a substrate 113 which may be glass or polycarbonate or another transparent polymeric material, thereby providing an adequate structural foundation for device 110, and which is transparent to light. One surface of substrate 113 is coated with optically transparent, electrically conductive layer 114 which will provide an electrical contact to cell 114 and is also transparent to light energy. An electrode (not shown) may be laterally attached to layer 114 so that device 110 may be coupled to other devices or an electrical load. A suitable material for layer 114 and compatible with the overall structure of device 110 is tin oxide (TO) which may be deposited on substrate 113 by methods known to one skilled in the art.

Other optically transparent, electrically conductive materials that may be used throughout the devices of the present invention include indium tin oxide, zinc oxide and zinc sulfate.

Cell 111 may next be formed on layer 114. As shown in Fig. 2, cell 111 may be a conventional N-I-P amorphous cell and may be deposited on layer 114 using normal fabrication techniques. When the amorphous cell is silicon its formation may be done in a vacuum chamber wherein silane ($SiH_4$) and/or other silicon-containing compounds are deposited on layer 114 at about 250°C. Silicon-hydrogen and/or silicon-fluorine-hydrogen alloys are useful to compensate for the lattice deficiences of the amorphous silicon.

An n-type amorphous silicon layer 115 may be made, as by doping the silane compound. This may be effected by adding diborane to the silane gas during the vacuum deposition process. A center intrinsic amorphous silicon layer 116 is deposited by not strongly doping, if at all, the silane gas during deposition. A p-type amorphous silicon layer 118 may be formed on layer 116, as by adding phosphine to the silane gas during deposition. Thus, a complete N-I-P solar cell has been formed as well as an optically transparent conductive layer 114 in contact therewith. An amorphous cell is desirable due to its lower cost and moderately high bandgap energy.

After cell 11 has been formed on conductive layer 114, an optically transparent, electrically conductive layer 119 may be formed on the exposed surface of layer 118. Layer 119 forms an ohmic connection between cells 111 and 112. To maximize the efficiency of device 110, a layer of indium-tin-oxide (ITO) has been found to be most suitable as it is optically transparent. It will thus be appreciated that according to the concepts of the present invention, cells 111 and 112 are optically and electrically in series. Other connection means could be used in place of the ITO layer such as a tunnel diode or metallic stripes or islands, however, the ITP layer provides a maximum transmission of light from cell 111 to cell 112 with minimal current losses due to recombination or resistance. It will be appreciated by one skilled in the art that if no more than two cells will be used there will be a corresponding connecting layer between each pair of cells so that all the cells are optically and electrically in series. Another advantage of the ITO layer is that the deposition can be done with conventional techniques known to one skilled in the art at temperatures compatible with the amorphous cell.

After layer 119 has been formed, cell 112 can next be added to the structure. According to the present invention, cell 112 may be composed of two semiconductor layer 120 and 121 of different compounds. Layer 120 may be formed as by evaporating semiconductor material onto layer 119 in a standard evaporation system. Deposition temperatures are maintained so that amorphous cell 111 will not be subjected to undesirable diffusion effects. Alternatively, the semiconductor material could be spray deposited or electrodeposited on layer 119.

Layer 121 is then formed on layer 120 by electrodeposition, spray deposition or evaporation. Thus, cell 112 may be formed by the same efficient processes as described hereinbefore with reference to cell 12 in Figure 1.

After cell 112 has been formed a second conductive layer 123 may be placed on layer 121. Layer 123 may include a gold ohmic contact surface contiguous to layer 121 with the bulk of layer 123 composed of nickel or other like conductive material. Layer 123 provides a contact surface to which an electrode (not shown) may be attached so as to complete the coupling of device 110 to another device or electrical load.

Operation of device 110 is substantially similar to that of device 10 in Figure 1 with the exception that the light energy, generally indicated by the numeral 124, enters device 110 through the glass substrate 113 and thereafter through optically transparent and electrically conductive layer 114 and then into cells 111 and 112. Again, the tandem configuration results in a high efficiency factor, and according to the concepts of the present invention, a novel photovoltaic device is disclosed which brings together, in a unique combination, solar cells producible by differing yet compatible processes at a substantially reduced cost for the overall device.

Inasmuch as the present invention is subject to many variations, modifications and changes in detail, a number of which have been expressly stated herein, it is intended that all matter described throughout this specification or shown in the accompanying drawings be interpreted as illustrative and not in a limiting sense. It should thus be evident that a device constructed according to the concepts of the present invention, and reasonably equivalent thereto, will accomplish the objects of the present invention and otherwise substantially improve the art of photovoltaic devices.

## Claims

1. A photovoltaic device having an optically transparent, electrically conductive layer and a second electrically conductive layer comprising: a plurality of cells including a first cell of one amorphous semiconductor material, said amorphous semiconductor material disposed as an active layer having a surface contacting the optically transparent, electrically conductive layer; and at least a second cell, which second cell has first and second semiconductor layers having different conductivity types, said first semiconductor layer comprising mercury cadmium telluride and having a surface electrically contacting the second electrically conductive layer, and means to connect said cells so that the same are optically and electrically in series in a tandem configuration.

2. A photovoltaic device having an optically transparent, electrically conductive layer and a second electrically conductive layer, the photovoltaic device comprising at least one amorphous silicon cell disposed as an active layer having one surface in contact with the optically transparent, electrically conductive layer and a cell comprising a first semiconductor layer of mercury cadmium telluride and a second semiconductor layer of cadmium sulfide in tandem configuration with the at least one amorphous silicon cell, said first semiconductor layer in contact with the second electrically conductive layer, the device further having means to connect said cells optically and electrically in series.

3. The device in accordance with claim 1 or 2, wherein said means to connect said cells is an optically transparent electrically conductive layer between said amorphous layer and said second semiconductor layer and in contact therewith.

4. The device in accordance with claim 3, wherein said optically transparent, electrically conductive connecting layer is indium-tin-oxide.

5. A device in accordance with claim 1 or 2, wherein said means to connect said cells includes tunnel diodes.

6. The device in accordance with claim 1, wherein said amorphous semiconductor layer has at least one homojunction.

7. The device in accordance with claim 6, wherein said amorphous layer comprises three contiguous sublayers including an n-type amorphous semiconductor sublayer, an intrinsic amorphous semiconductor sublayer and a p-type amorphous semiconductor sublayer.

8. The device in accordance with claim 6, wherein said amorphous semiconductor layer comprises silicon.

9. The device in accordance with claim 2 or 8, wherein said amorphous silicon layer comprises at least three contiguous sublayers including an n-type conductivity sublayer, an intrinsic sublayer and a p-type conductivity sublayer.

10. The device in accordance with claim 9, wherein said n-type conductivity sublayer is doped with phosphorus.

11. The device in accordance with claim 9, wherein said p-type conductivity sublayer is doped with boron.

12. The device in accordance with claim 9, wherein at least one of the n-type sublayer and the p-type sublayer includes microcrystalline semiconductor material.

13. The device in accordance with claim 1, wherein said first cell includes an amorphous semiconductor material other than silicon.

14. The device in accordance with claim 1 or 2, wherein said optically transparent, electrically conductive layer is a transparent conductive oxide.

15. The device in accordance with claim 1 or 2, wherein said optically transparent, electrically conductive layer is indium tin oxide.

16. The device in accordance with claim 1 or 2, wherein said second electrically conductive layer comprises chromium, nickel, gold, copper and mixtures thereof.

17. The device in accordance with claim 2, wherein said device further comprises a substrate material.

18. The device in accordance with claim 17, wherein said substrate material is stainless steel.

19. The device in accordance with claim 17, wherein said substrate material is glass.

20. The device in accordance with claim 1, wherein said second semiconductor layer comprises at least one semiconductor material selected from the group consisting of cadmium sulfide, cadmium selenide, zinc oxide, zinc selenide and cadmium zinc selenide.

21. A tandem-configuration photovoltaic device comprising an electrically conductive substrate having disposed thereon a cadmium sulfide/mercury cadmium telluride cell, the mercury cadmium telluride in contact with said substrate; an amorphous silicon p-i-n cell, the p-type sublayer being nearest the cadmium sulfide/mercury cadmium telluride cell; a layer of indium tin oxide disposed between the cadmium sulfide/mercury cadmium telluride cell and the amorphous silicon cell; and a layer of an optically transparent, conductive material disposed on top of the device.

22. The device in accordance with claim 21, wherein said amorphous silicon cell additionally includes an amorphous semiconductor material other than silicon.

23. The device in accordance with claim 21, wherein at least one of the p-type sublayer and n-type sublayer of said amorphous silicon cell includes microcrystalline semiconductor material.

24. The photovoltaic device in accordance with claim 21, wherein said layer of optically transparent, conductive material is indium tin oxide.

25. The photovoltaic device in accordance with claim 21, wherein a current collection grid is disposed over said layer of optically transparent, conductive material.

26. The photovoltaic device in accordance with claim 21, wherein a layer of glass is disposed over said layer of optically transparent conductive material.

27. The device in accordance with claim 1, 2 or 21 including at least two amorphous semiconductor cells.

28. A process for the production of a multiple cell photovoltaic device having at least a first cell comprising an amorphous semiconductor material and at least a second cell comprising first and second semiconductor layers composed of materials having different conductivity types, said first semiconductor layer being selected from cadmium telluride and mercury cadmium telluride, and said second semiconductor layer comprising cadmium sulfide, the process comprising the steps of:
a) electrodepositing said first semiconductor layer having a first conductivity type onto an electrically conductive material;
b) electrodepositing a second semiconductor layer of cadmium sulfide having a conductivity type different than the conductivity type of the first semiconductor layer onto the first semiconductor layer to form said second cell;
c) depositing onto the second semiconductor layer of cadmium sulfide a layer of an optically transparent, electrically conductive material; and
d) depositing onto the optically transparent electrically conductive material layers of an amorphous semiconductor material to form said first cell.

29. A process for the production of a multiple cell photovoltaic device having at least a first cell comprising an amorphous semiconductor material and at least one cell comprising first and second semiconductor layer composed of materials having different conductivity types, said first semiconductor layers being selected from cadmium telluride and mercury cadmium telluride, and said second semiconductor layer comprising cadmium sulfide, the process comprising the steps of:
a) depositing onto an optically transparent, electrically conductive substrate layers of an amorphous semiconductor material to form at least said first cell;
b) depositing onto said amorphous semiconductor material a layer of a transparent, electrically conductive material;
c) electrodepositing a second semiconductor layer comprising cadmium sulfide having a first conductivity type onto the exposed transparent, electrically conductive layer;
d) electrodepositing said first semiconductor layer of a conductivity type different than the conductivity type of the cadmium sulfide layer onto the cadmium sulfide layer; and
e) depositing onto the first semiconductor layer a layer of an electrically conductive material.

30. The process in accordance with claim 28 or 29, wherein said optically transparent, electrically conductive material is indium tin oxide.

31. The process in accordance with claim 28 or 29, wherein at least one cell comprising an amorphous semiconductor material comprises an amorphous silicon cell having a p-type sublayer, an intrinsic sublayer and an n-type sublayer.

32. The process in accordance with claim 31, wherein at least one cell comprising an amorphous semiconductor material includes an amorphous semiconductor material other than silicon.

33. The process in accordance with claim 31, wherein at least one of the n-type sublayer and p-type sublayer includes microcrystalline semiconductor material.

34. The process in accordance with claim 28 or 29 including depositing at least one additional cell of amorphous semiconductor material onto said first cell.

35. The process in accordance with claim 28 or 29, wherein said layers of amorphous semiconductor material are deposited by a glow discharge process.

36. The process in accordance with claim 29, wherein said optically transparent, electrically conductive substrate comprises a layer of glass having a layer of a transparent, conductive oxide thereon.

37. The process in accordance with claim 29, wherein said optically transparent, electrically conductive substrate comprises a layer of polycarbonate material having a layer of a transparent, conductive oxide thereon.

38. The process in accordance with claim 36 or 37, wherein said transparent, conductive oxide is indium tin oxide.

39. The process in accordance with claim 28 or 29, wherein said electrically conductive material is stainless steel.

40. The process in accordance with claim 39, wherein a layer of chromium-coated gold is disposed between said first semiconductor layer and said stainless steel layer.

# FIG.1

FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-4 536 607 (WEISMANN)<br><br>* column 3, lines 63-64; column 4, lines 1-5; column 5, lines 16-38; column 6, line 1 - column 7, line 50; column 8, lines 1-41 * | 1-4,6-25,28-33,35-40 | H 01 L 31/06<br>H 01 L 25/08 |
| Y | EP-A-0 152 197 (BP PHOTOVOLTAICS LTD.)<br><br>* abstract; figure 4 * | 1-4,6-25,28-33,35-40 | |
| A | US-A-4 292 092 (HANAK)<br><br>* column 2, lines 34-51; column 5, lines 47-48; claims 3, 4 * | 1,2,5-9,13-15,17,19-21,27-32,35-38 | **TECHNICAL FIELDS SEARCHED (Int. Cl.4)**<br><br>H 01 L 31/06<br>H 01 L 25/04 |
| A | EXTENDED ABSTRACTS, vol. 84, no. 2, 1984, pages 426-427, abstract no. 302, New Orleans, Louisiana, US; J. PHILLIPS et al.: "Thin film tandem solar cells"<br>* figure 1 * | 1-4,21,28,30 | |

-/-

The present search report has been drawn up for all claims

| Place of search | Date of completion of the search | Examiner |
|---|---|---|
| BERLIN | 28-11-1986 | PRETZEL B.C. |

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| A | GB-A-2 083 705 (ENERGY CONVERSION DEVICES)<br><br>* page 10, lines 1-130 *<br><br>----- | 6-9,13<br>-15,17<br>,18,22<br>,24,25<br>,27,31<br>,32,34 | |

TECHNICAL FIELDS SEARCHED (Int. Cl.4)

The present search report has been drawn up for all claims

| Place of search | Date of completion of the search | Examiner |
|---|---|---|
| BERLIN | 28-11-1986 | PRETZEL B.C. |